(19) **Europäisches Patentamt**
**European Patent Office**
**Office européen des brevets**

(11) **EP 2 951 497 B1**

(12) **EUROPEAN PATENT SPECIFICATION**

(45) Date of publication and mention
of the grant of the patent:
**29.01.2020 Bulletin 2020/05**

(21) Application number: **14746260.0**

(22) Date of filing: **30.01.2014**

(51) Int Cl.:
***F21V 7/10*** (2006.01)

(86) International application number:
**PCT/US2014/013854**

(87) International publication number:
**WO 2014/120925 (07.08.2014 Gazette 2014/32)**

(54) **LIGHT ENGINE**

LICHT-MOTOR

GÉNÉRATEUR DE LUMIÈRE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **30.01.2013 US 201361758660 P
15.03.2013 US 201313841074
15.03.2013 US 201313842521
15.03.2013 US 201313840563
15.03.2013 US 201313839949
10.07.2013 US 201313938877
09.12.2013 US 201314101051
09.12.2013 US 201314101132
09.12.2013 US 201314101129
09.12.2013 US 201314101099
09.12.2013 US 201314101147
09.12.2013 US 201314101086
30.12.2013 US 201361922017 P**

(43) Date of publication of application:
**09.12.2015 Bulletin 2015/50**

(73) Proprietor: **IDEAL INDUSTRIES LIGHTING LLC
Sycamore, Illinois 60178 (US)**

(72) Inventors:
• **YUAN, Zongjie
Grayslake, IL 60030 (US)**
• **WILCOX, Kurt S.
Libertyville, IL 60048 (US)**
• **MA, Jiayin
Newtonville, NY 12110 (US)**

(74) Representative: **Hautier IP
1, Rue du Gabian
Le Thalès - 12 Etg - Bloc A
98000 Monaco (MC)**

(56) References cited:
**US-A- 5 806 955        US-A1- 2004 080 938
US-A1- 2008 186 273     US-A1- 2010 128 483
US-A1- 2010 128 483     US-A1- 2010 238 645
US-A1- 2011 273 079     US-A1- 2011 305 018
US-B1- 7 160 010        US-B1- 8 328 403**

**Description**

FIELD OF THE INVENTION

The present inventive subject matter relates to optical waveguides, and more particularly to optical waveguides for general lighting.

BACKGROUND OF THE INVENTION

An optical waveguide mixes and directs light emitted by one or more light sources, such as one or more light emitting diodes (LEDs). A typical optical waveguide includes three main components: one or more coupling elements, one or more distribution elements, and one or more extraction elements. The coupling component(s) direct light into the distribution element(s), and condition the light to interact with the subsequent components. The one or more distribution elements control how light flows through the waveguide and is dependent on the waveguide geometry and material. The extraction element(s) determine how light is removed by controlling where and in what direction the light exits the waveguide.

When designing a coupling optic, the primary considerations are: maximizing the efficiency of light transfer from the source into the waveguide; controlling the location of light injected into the waveguide; and controlling the angular distribution of the light in the coupling optic. One way of controlling the spatial and angular spread of injected light is by fitting each source with a dedicated lens. These lenses can be disposed with an air gap between the lens and the coupling optic, or may be manufactured from the same piece of material which defines the waveguide's distribution element(s). Discrete coupling optics allow numerous advantages such as higher efficiency coupling, controlled overlap of light flux from the sources, and angular control of how the injected light interacts with the remaining elements of the waveguide. Discrete coupling optics use refraction, total internal reflection, and surface or volume scattering to control the distribution of light injected into the waveguide.

After light has been coupled into the waveguide, it must be guided and conditioned to the locations of extraction. The simplest example is a fiber-optic cable, which is designed to transport light from one end of the cable to another with minimal loss in between. To achieve this, fiber optic cables are only gradually curved and sharp bends in the waveguide are avoided. In accordance with well-known principles of total internal reflectance light traveling through a waveguide is reflected back into the waveguide from an outer surface thereof, provided that the incident light does not exceed a critical angle with respect to the surface.

In order for an extraction element to remove light from the waveguide, the light must first contact the feature comprising the element. By appropriately shaping the waveguide surfaces, one can control the flow of light across the extraction feature(s). Specifically, selecting the spacing, shape, and other characteristic(s) of the extraction features affects the appearance of the waveguide, its resulting distribution, and efficiency.

Hulse U.S. Patent No. 5,812,714 discloses a waveguide bend element configured to change a direction of travel of light from a first direction to a second direction. The waveguide bend element includes a collector element that collects light emitted from a light source and directs the light into an input face of the waveguide bend element. Light entering the bend element is reflected internally along an outer surface and exits the element at an output face. The outer surface comprises beveled angular surfaces or a curved surface oriented such that most of the light entering the bend element is internally reflected until the light reaches the output face

Parker et al. U.S. Patent No. 5,613,751 discloses a light emitting panel assembly that comprises a transparent light emitting panel having a light input surface, a light transition area, and one or more light sources. Light sources are preferably embedded or bonded in the light transition area to eliminate any air gaps, thus reducing light loss and maximizing the emitted light. The light transition area may include reflective and/or refractive surfaces around and behind each light source to reflect and/or refract and focus the light more efficiently through the light transition area into the light input surface of the light emitting panel. A pattern of light extracting deformities, or any change in the shape or geometry of the panel surface, and/or coating that causes a portion of the light to be emitted, may be provided on one or both sides of the panel members. A variable pattern of deformities may break up the light rays such that the internal angle of reflection of a portion of the light rays will be great enough to cause the light rays either to be emitted out of the panel or reflected back through the panel and emitted out of the other side.

Shipman, U.S. Patent No. 3,532,871 discloses a combination running light reflector having two light sources, each of which, when illuminated, develops light that is directed onto a polished surface of a projection. The light is reflected onto a cone-shaped reflector. The light is transversely reflected into a main body and impinges on prisms that direct the light out of the main body.

Simon U.S. Patent No. 5,897,201 discloses various embodiments of architectural lighting that is distributed from contained radially collimated light. A quasi-point source develops light that is collimated in a radially outward direction and exit means of distribution optics direct the collimated light out of the optics.

Kelly et al. U.S. Patent No. 8,430,548 discloses light fixtures that use a variety of light sources, such as an incandescent bulb, a fluorescent tube and multiple LEDs. A volumetrie diffuser controls the spatial luminance uniformity and angular spread of light from the light fixture. The volumetrie diffuser includes one or more regions of volumetrie light scattering particles. The volumetrie diffuser may be used in conjunction with a waveguide to extract light.

Dau et al U.S. Patent No. 8,506, 112 discloses illumination deviees having multiple light emitting elements, such as LEDs disposed in a row. A collimating optical element receives light developed by the LEDs and a light guide directs the collimated light from the optical element to an optical extractor, which extracts the light.

A.L.P. Lighting Components, Inc. of Niles, Illinois, manufactures a waveguide having a wedge shape with a thick end, a narrow end, and two main faces therebetween. Pyramid-shaped extraction features are formed on both main faces. The wedge waveguide is used as an exit sign such that the thick end of the sign is positioned adjacent a ceiling and the narrow end extends downwardly. Light enters the waveguide at the thick end and is directed clown and away from the waveguide by the pyramid-shaped extraction features.

REO et al. U.S. Patent Application 2010/128483 A1 discloses a luminaire using LEDs which may comprise a refractor. Said refractor may be used in front of the LEDs to blend the luminous intensity so that the luminaire does not emit light that appears as a plurality of bright points. The refractor can have collimators for each of the LEDs or can be injection molded as a single piece.

PARKYN et al. U.S. Patent 5,806,955 discloses radiant energy transmitting body means, in the shape of a cover or dome, has multiple facets or elements, each facet having an entry face to receive impingement of radiation, an exit face to pass energy to the exterior of the body, and an internal reflection face angled relative to the entry and exit faces to reflect radiant energy incident on the reflection face toward the exit face. The multiple facets may extend annularly about and define a common axis.

Law-profile LED-based luminaires have recently been developed (e.g., General Electric's ET series panel troffers) that utilize a string of LED components directed into the edge of a waveguiding element (an "edge-lit" approach). However, such luminaires typically suffer from low efficiency due to losses inherent in coupling light emitted from a predominantly Lambertian emitting source such as a LED component into the narrow edge of a waveguide plane.

US 2008/186273 A1 discloses a light engine according to the preamble of claim 1.

SUMMARY OF THE INVENTION

An optical waveguide assembly includes a plurality of separate body sections each having a coupling cavity for receiving an LED element and a light extraction feature spaced from the coupling cavity, and a mounting structure surrounding the plurality of body sections that maintains the plurality of body sections in assembled relationship. The waveguide assembly may be incorporated into a light engine.

According to the invention a light engine comprises an optical waveguide including a plurality of body sections each of a wedge-shape comprising first and second continuously curved outer walls disposed at an outer portion of the optical waveguide and that meet at an inflection point spaced from another body section and having a recess for receiving at least one LED and a plurality of curved light extraction features surrounding the recess and a mounting structure surrounding the plurality of body sections that maintains the plurality of body sections in assembled relationship. The light engine further includes a base mounting surface and a plurality of LEDs disposed on a circuit board wherein the circuit board, the mounting structure, and assembled body sections are secured relative to the base mounting surface.

Other aspects and advantages of the present invention will become apparent upon consideration of the following detailed description and the attached drawings.

BRIEF DESCRIPTION OF THE DRAWINGS

FIG. 1 is an isometric view looking up from below of a luminaire incorporating a waveguide according to an embodiment of the present invention;

FIG. 2 is an isometric view looking down from above of the luminaire of FIG. 1;

FIG. 3 is an exploded isometric view of the luminaire of FIG. 1;

FIG. 4 is an isometric view of the light engine and heat exchanger of FIG. 1;

FIG. 5 is a sectional view taken generally along the lines 5-5 of FIG. 4;

FIG. 6 is an enlarged isometric view of a first side of an optical segment used in the luminaire of FIG. 1;

FIG. 7 is a sectional view taken generally along the lines 7-7 of FIG. 6;

FIG. 7A is a sectional view identical to FIG. 7 illustrating sample dimensions for the optical segment of FIG. 6;

FIG. 8 is a plan view of a second side of the optical segment of 6;

FIG. 8A is a plan view identical to FIG. 8 illustrating further sample dimensions for the optical segment of FIG. 6;

FIG. 9 is a diagrammatic view illustrating a converging beam spread developed by the luminaire of FIGS. 1-3;

FIG. 10 is an enlarged isometric view of a first side of a further embodiment of an optical segment;

FIGS. 11-16 are perspective views of further embodiments of optical waveguides comprising a plurality of optical segments; and

FIGS. 17-20 are elevational views of alternative embodiments of LED elements that may be used in the waveguides of FIGS. 11-16.

DETAILED DESCRIPTION OF THE PREFERRED EMBODIMENTS

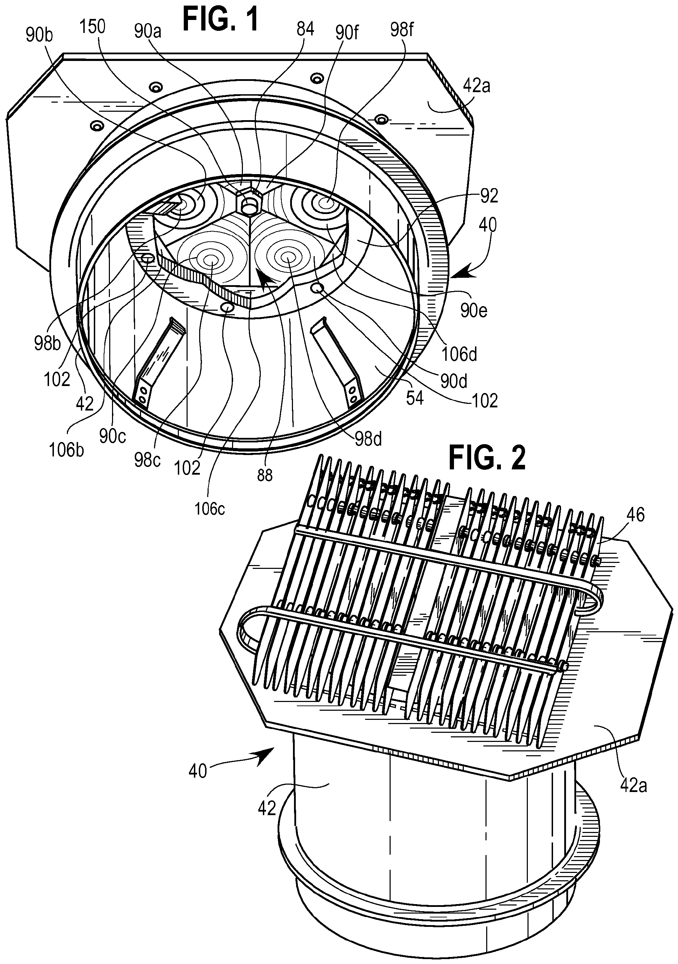

Referring first to FIGS. 1-3, a luminaire 40 includes a housing 42 to which a light engine 44 and a heat exchanger 46 are secured. Electrical power is supplied to components of the light engine 44 via electrical components and wires (not shown) disposed in electrical boxes and conduit sections (not shown) mounted in any suitable fashion on the housing 42. A diffuser ring (not shown) may extend into an opening 54 of the housing 42, if desired. The luminaire 40 may be of any desired size and/or shape. In the illustrated embodiment, the luminaire housing 42 has an opening diameter of about 16 cm, but may be as small as about 6 or larger. Also in the illustrated embodiment, the luminaire 40 is about 20 cm in height, but may be as small as 4 cm or larger.

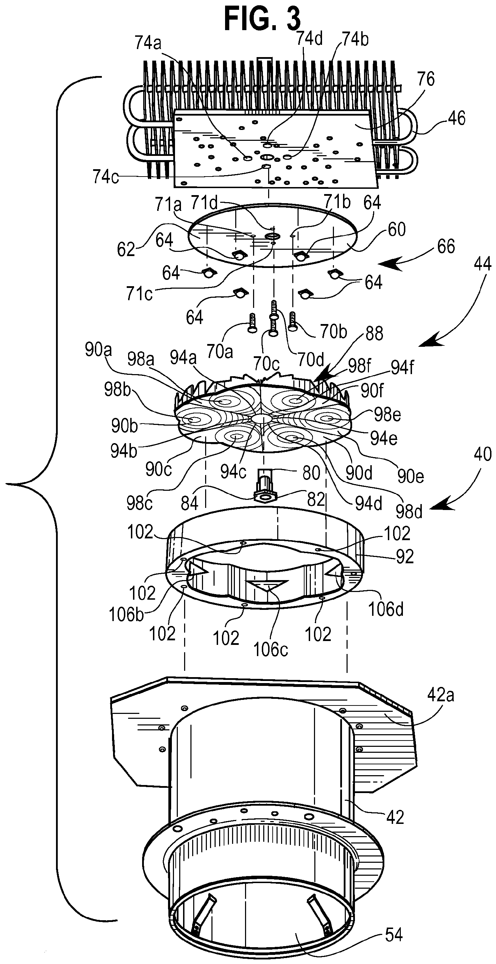

With specific reference to FIG. 3, the light engine 44 includes a circuit board 60, which, in the illustrated embodiment, may be coated or covered by a white or specular reflective material 62. A plurality of spaced LED elements 64 together comprising a light source 66 is mounted on the material 62 (or, alternatively, directly on the circuit board 60) and the LED elements 64 are electrically coupled to an electrical power circuit (not shown) that is, for example, disposed in the electrical boxes noted above. The electrical power circuit may instead be located remotely, or a portion may be disposed in at least one of the electrical boxes and the remainder located remotely, as desired. In any event, the power circuit is designed to operate the light source 66 with AC or DC power in a desired fashion to produce light of a desired intensity and appearance. Preferably, the light source 66 develops relatively high intensity light appropriate for outdoor or indoor general illumination purposes including light similar or identical to that provided by an incandescent, halogen, or other lamp that may be incorporated in a parking lot light, a road way light, a light that produces a wall washing effect, a light usable in a large structure, such as a warehouse, an arena, a downlight, etc. The luminaire 40 is particularly adapted to develop high intensity light greater than 1000 lumens, and more particularly greater than 2000-5000 lumens, and can even be configured to develop 20,000 or more lumens by adding LED elements 64 and waveguide body sections described hereinafter.

Each LED element 64 may be a single white or other color LED, or each may comprise multiple LEDs either mounted separately or together on a single substrate or package to form a module including, for example, at least one phosphor-coated LED either alone or in combination with at least one color LED, such as a green LED, a yellow LED, a red LED, etc. In those cases where a soft white illumination is to be produced, each LED module 64 typically includes one or more blue shifted yellow LEDs and one or more red LEDs. Different color temperatures and appearances could be produced using other LED combinations, as is known in the art. In one embodiment, the light source comprises any LED, for example, an MT-G LED incorporating TrueWhite® LED technology or as disclosed in U.S. Patent Application 13/649,067, filed October 10, 2012, entitled "LED Package with Multiple Element Light Source and Encapsulant Having Planar Surfaces" by Lowes et al., (Cree Docket No. P1912US1-7), as developed and manufactured by Cree, Inc., the assignee of the present application. If desirable, a side emitting LED disclosed in U.S. Patent No. 8,541,795, may be utilized inside the waveguide body. In some embodiments, the light source may comprise one or more LEDs disposed vertically within the coupling cavity. In any of the embodiments disclosed herein the LED(s) preferably have a lambertian light distribution, although each may have a directional emission distribution (e.g., a side emitting distribution), as necessary or desirable. More generally, any lambertian, symmetric, wide angle, preferential-sided, or asymmetric beam pattern LED(s) may be used as the light source.

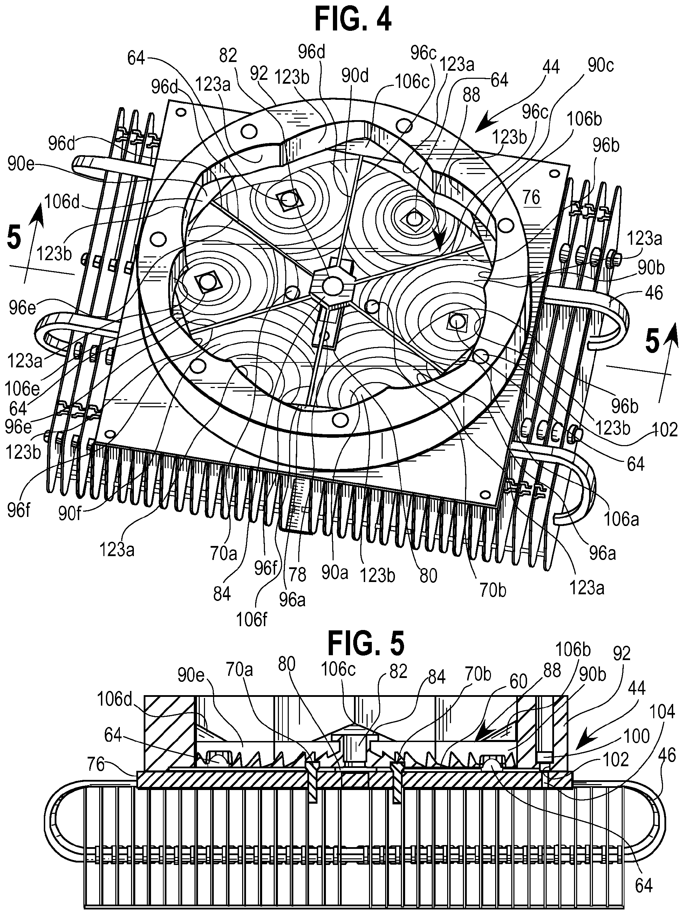

The circuit board 60 is directly or indirectly (e.g., via an electrically insulating layer) secured to the heat exchanger 46. The heat exchanger 46 preferably has heat pipes that conduct a cooling fluid and fins to dissipate heat. The heat exchanger 46 is preferably arranged to eliminate thermal crosstalk between the LEDs and the power circuit. Two fasteners, such as screws 70a, 70b, extend through bores 71a, 71b in the circuit board 60 and into threaded bores 74a, 74b (FIG. 3) in a base mounting surface in the form of a heat exchanger plate 76. Two further fasteners, such as screws 70c, 70d, extend though bores 78 in a post mounting plate 80 (FIGS. 3-5) and through aligned bores 71c, 71d in the circuit board 60 and into threaded bores 74c, 74d, respectively, in the heat exchanger plate 76 (FIG. 5). A post 82 having a circumferential end flange 84 is carried by the plate 80 and maintained in a stationary position thereby.

An optical waveguide 88 comprising a plurality of separate waveguide body sections 90a-90f is secured proximate the circuit board 60 by a mounting structure in the form of a mounting ring 92. Specifically, inner portions 94a-94f (FIG. 3) of the waveguide body sections 90a-90f, respectively, are placed between the circumferential end flange 84 and the circuit board 60 such that side surfaces 96a-96f (FIG. 4) of adjacent body sections 90a-90f abut one another, and so that the LED elements 64 are disposed in recesses comprising coupling cavities 98a-98f of the body sections 90a-90f, respectively, (see FIGS. 1 and 3). The mounting ring 92 is thereafter secured to the heat exchanger plate 76 by fasteners, such as further screws 100 that extend through bores 102 and into threaded bores 104, respectively (FIGS. 1 and 3-5). Inwardly-directed triangular webs 106a-106f of the mounting ring 92 bear against and capture outer portions 108a-108f of the body sections 90a-90f so that the body sections 90 are maintained in assembled relationship adjacent the circuit board 60 by the webs 106 and the end flange 84 of the post 82.

Referring specifically to FIGS. 1-3, the housing 42 includes a mounting plate 42a that is secured by threaded fasteners, such as screws (not shown), to the heat exchanger plate 76. The light engine 44 is thereby disposed in the housing 42 with the body sections facing the opening 54 and the heat exchanger 46 facing upwardly from the mounting plate 42a, as seen in FIGS. 1 and 2.

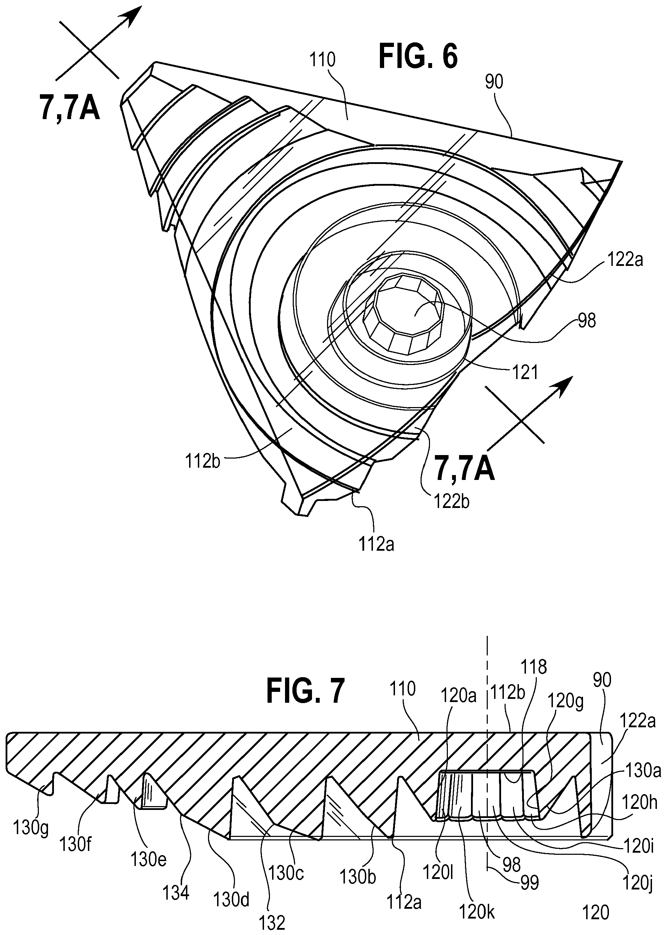

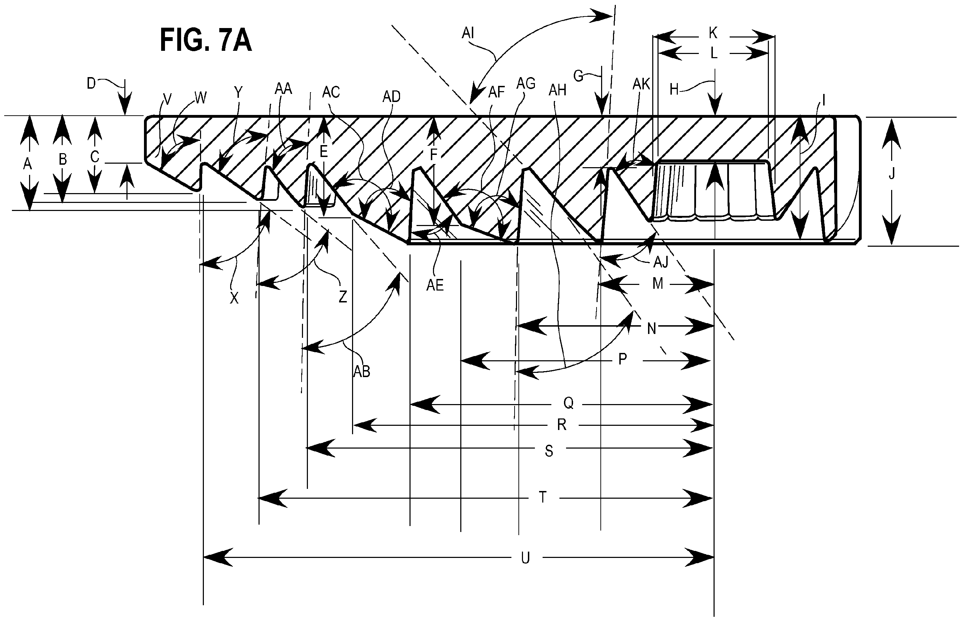

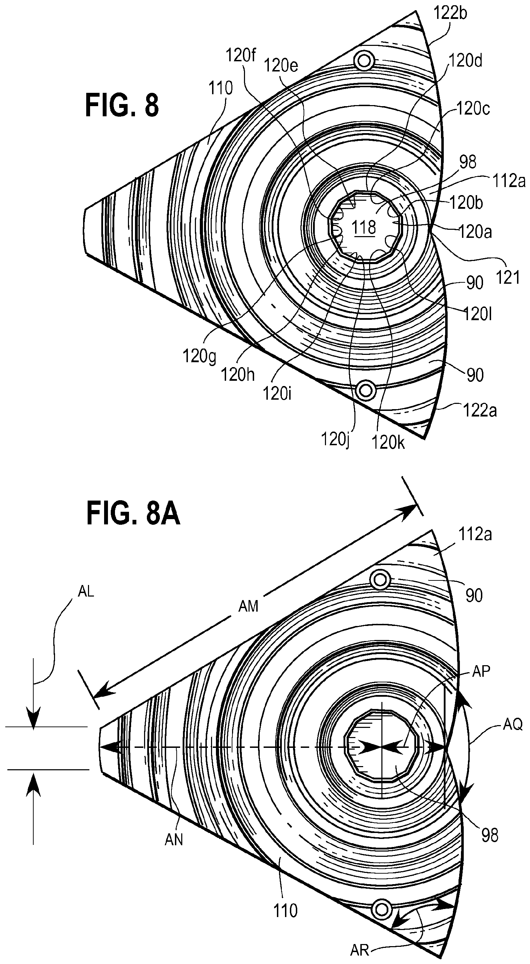

Referring to FIGS. 6-8 the waveguide body sections 90 are all identical to one another and each is symmetric about view lines 7-7 in FIG. 6 (the view lines 7-7 are referred to as the symmetry plane of the body section 90 hereinafter). Each section 90 has a main body of material 110 having a width substantially greater than an overall thickness thereof and is substantially or completely wedge-shaped (otherwise also referred to a pie slice shape) in a dimension transverse to the width and thickness (FIG. 8). In the illustrated embodiment, each waveguide body section 90 includes a first or outer side or surface 112a, a second opposite inner side or surface 112b, and the coupling cavity 98, which in the illustrated embodiment, comprises a blind bore that does not extend fully through the waveguide body section 90 from the first side 112a to the second side 112b. Also in the illustrated embodiment, the coupling cavity 98 has a central axis 99 (FIG. 7) coincident with the symmetry plane and is defined by a base wall 118 and substantially or fully planar side walls or surfaces comprising twelve equally-sized facets 120a-120l (FIGS. 7 and 8) that are preferably (although not necessarily) disposed at other than a perpendicular angle relative to the first and second sides 112a, 112b of the waveguide body section 90. Further, in the illustrated embodiment, the coupling cavity 98 is disposed inside outer edge surfaces of the body section 90 and is not centrally located in the body section 90, but rather, is offset toward and aligned with an inflection portion 121 of outer curved surfaces 122a, 122b that define an outer perimeter of the outer portion 108. In all the embodiments disclosed herein, the facets 120a-120l are preferably polished and optically smooth. The coupling cavities may have a different shape, such as circular cylindrical, if desired, such as disclosed in co-pending U.S. Patent Application No. 13/839,949.

Also preferably, the outer curved surfaces 122a, 122b are polished and optically smooth. They meet at the inflection portion 121. In the preferred embodiment the mounting ring 92 further includes a plurality of first and second inner surfaces 123a, 123b, respectively, (FIG. 4) that substantially or completely conform to the outer curved surfaces 122a, 122b of the body sections 90a-90f once the sections 90 are assembled together. Also in the preferred embodiment, the first and second surfaces 123a, 123b have a depth greater than depths of the body sections 90 (seen as dimension J in FIG. 7A), such that the surfaces 123a, 123b extend beyond the surfaces 122a, 122b, respectively, (refer to FIG. 1) and the first and second sections 123a, 123b are coated with a specular or white reflective material, if desired. The outer curved surfaces 122a, 122b and the first and second surfaces 123a, 123b minimize light leakage from the outer radial ends of the waveguide body sections 90. Each of the surfaces 122a, 122b, 123a, 123b preferably has a continuously curved shallow parabolic, elliptical, or round shape and are, in the illustrated embodiment, of similar or identical shapes. In one embodiment, the surfaces 122a, 122b and 123a, 123b are mirror images of one another with respect to the symmetry plane. In a particular embodiment, the surfaces 122a, 122b and 123a, 123b are sections of circles having radii of curvature greater than 20 mm, and more preferably between about 50 and about 300 mm, and most preferably equal to about 55 mm. In this embodiment the centers of the radii of curvature are preferably equally spaced from and disposed on opposite sides of the symmetry plane 7-7 of FIG. 6, in keeping with preferred symmetrical shape of the body section 90.

When the light source 66 is energized, light developed by the LED element 64 disposed in each coupling cavity 98 travels within the cavity 98 and a portion of the light enters into the associated waveguide body section 90 in a generally transverse direction along the width of the body of material 110. Other light is directed outwardly through the second side 122b opposite the LED element. If desired, a portion of the body section 90 opposite the coupling cavity 98 may be partially or fully transparent or translucent, as desired, to allow at least some light to be transmitted therethrough (for example, at least about 5% of the light may be transmitted through this portion). A plurality of extraction features 130 are disposed in the body section 90 to extract light traveling through the waveguide body section 90. The spacing, number, size and geometry of extraction features 130 determine the mixing and distribution of light in the waveguide body section 90 and light exiting the section 90. In the illustrated embodiment, the extraction features 130 comprise a series of ridges separated by intervening troughs at least some of which define one or more inverted V-shapes in cross section, as seen in FIG. 7. Also in the illustrated embodiment, one (and perhaps more) of the extraction features 130a is continuous (i.e., it extends fully in a continuous manner about the coupling cavity 98), and fully surrounds the coupling cavity 98, while the remaining extraction features 130b-130g comprise continuous or discontinuous ridges (i.e., partial circular or other curved and/or linear features continuously or discontinuously partially surrounding the coupling cavity 98) separated by intervening troughs. In the illustrated embodiment, all of the extraction features are circular (i.e., annular) and continuous or discontinuous. Two of the extraction features 130c and 130d have inflections (i.e., bends) 132, 134 in the ridges, as seen in FIG. 7, although these inflections need not be provided or other inflections or other surface features may be provided in any of the features 130. Still further in the illustrated embodiment all of the extraction features 130 are coaxial with the central axis 99 of the coupling cavity 98, and all are, therefore, symmetric with respect to the axis of symmetry of the body section 90. In addition to the foregoing, the waveguide body section 90 is tapered in an overall sense from the central axis 99 of the coupling cavity to an outside edge in that there is less material at the radially outside edges of the waveguide body section 90 than portions adjacent the central axis 99. Such tapering may be effectuated by providing extraction features that become deeper and/or are more widely separated with distance from the center of the waveguide body section 90, as noted in greater detail hereinafter. The tapering maximizes the possibility that substantially all the light introduced into the waveguide body section 90 is extracted over a single pass of the light through the body section 90. This results in substantially all of the light striking the radially outward surfaces of the extraction features 130, which are carefully controlled so that the extraction of light is also carefully controlled. The combination of tapering with the arrangement of extraction features results in improved color mixing with minimum waveguide thickness and excellent control over the emitted light.

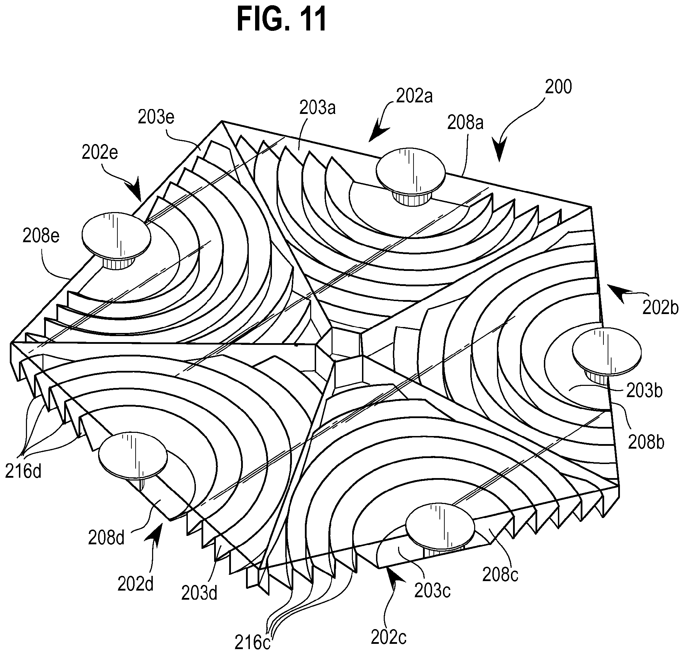

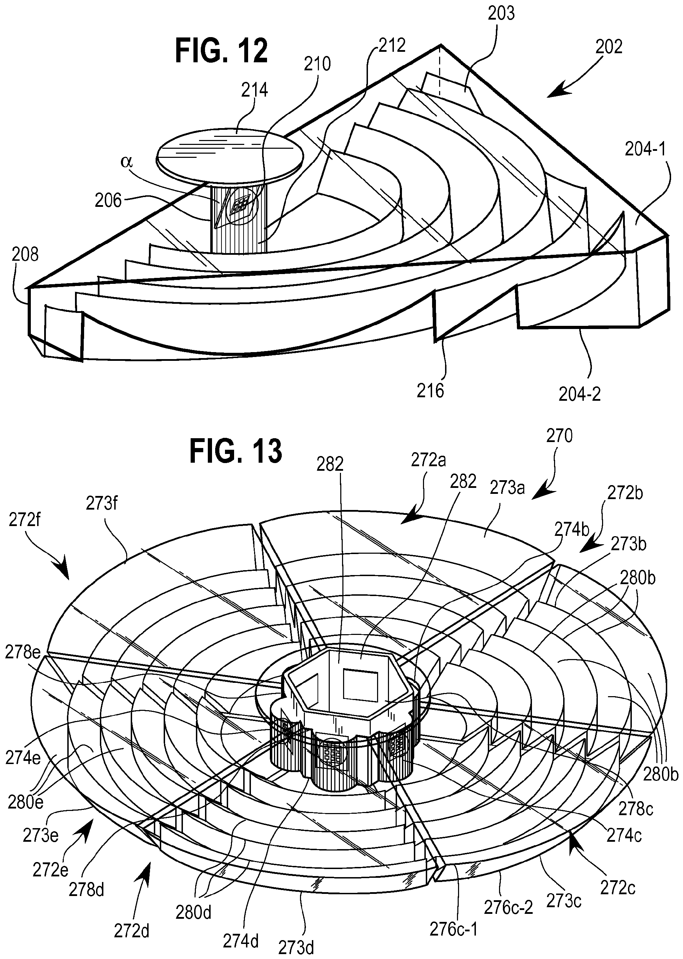

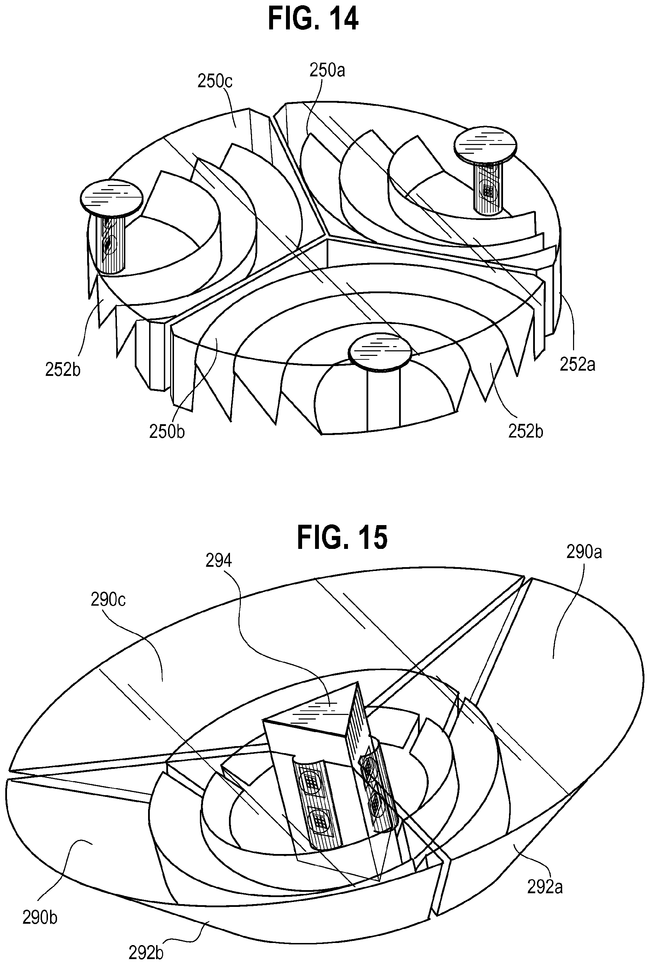

In the illustrated embodiment, the light emitted out the waveguide body sections 90 is mixed such that point sources of light in the LED elements 64 are not visible to a significant extent and the emitted light is controlled and collimated to a high degree. As shown in FIG. 7, the coupling cavities 98a-98f may extend fully through the body sections 90a-90f, respectively, although each coupling cavity 98a-98f, or one or more coupling cavities 98a-98f, may extend only partially through the body section 90a-90f, respectively. It should be noted that the light sources need not be located at one or more interior portions of the waveguide body section (which embodiments are referred to as "interior lit"). Rather, the coupling cavity may be positioned along the inner portion 94 (refer to FIGS. 13 and 15) or outer curved surfaces 122a, 122b (refer to FIGS. 11, 12, 14, and 16) to obtain an "edge lit" waveguide, as described in greater detail below. In edge lit embodiments, the light source may be above, below, and/or to the side of the edge and aligned therewith as shown and described in co-pending U.S. Patent Application No. 14/101,086, entitled "Optical Waveguides and Luminaires Incorporating Same," filed December 9, 2013 (Cree docket no. P2126US1). A reflecting cover or member may be disposed over, under, or otherwise adjacent to the light source in any of the embodiments disclosed herein. In other embodiments, the light source may be disposed adjacent an elongate coupling section. In some embodiments, the waveguide body section may include more than one coupling cavity. A waveguide body section may be interior lit and/or edge lit, and/or include one or more elongate coupling cavities, as desired. Further, it may be desirable to tilt the light source at an angle $\alpha$ within the coupling cavity as shown in FIG. 12. For example, where the light source extends into the waveguide body section from an edge thereof as shown in FIG. 12, the central axis of the light source may be disposed at a non-zero angle with respect to the lateral extent of the waveguide body section. Where the light source extends into a coupling cavity transverse to the lateral extent of the waveguide body section as shown in FIG. 5, the central axis of the light source may be disposed at a non-zero angle relative to the central axis of the coupling cavity.

In the illustrated embodiment shown in FIGS. 7 and 8, each waveguide body section 90 is made of any optical grade material including one or more of acrylic, air, polycarbonate, molded silicone, glass, and/or cyclic olefin copolymers, and combinations thereof, particularly (although not exclusively) in a layered arrangement to achieve a desired effect and/or appearance. In one example, the waveguide body section 90 has the dimensions noted in the following table and as seen in FIGS. 7A and 8A. It should be noted that the dimensions in the following table as exemplary only and not limiting:

Table 1

| REFERENCE (FIGS. 7A and 8A) | NOMINAL DIMENSION (Millimeters - unless otherwise specified) |
|---|---|
| A | 9 |

(continued)

| REFERENCE (FIGS. 7A and 8A) | NOMINAL DIMENSION (Millimeters - unless otherwise specified) |
|---|---|
| B | 8.1 |
| C | 7.2 |
| D | 4.2 |
| E | 9.06 |
| F | 10.03 |
| G | 4.92 |
| H | 4.2 |
| I | 11.6 |
| J | 11.9 |
| K | 9.94 |
| L | 11.4 |
| M | 10.44 |
| N | 17.64 |
| P | 33.6 |
| Q | 28.5 |
| R | 33.6 |
| S | 38.1 |
| T | 42.18 |
| U | 48 |
| V | 120° |
| W | 60° |
| X | 60° |
| Y | 60° |
| Z | 43° |
| AA | 38° |
| AB | 45° |
| AC | 160° |
| AD | 65° |
| AE | 40° |
| AF | 145° |
| AG | 75° |
| AH | 42° |
| AI | 42° |
| AJ | 33° |
| AK | 28° |
| AL | 7.8 |
| AM | 71.5 |
| AN | 53.2 |

(continued)

| REFERENCE (FIGS. 7A and 8A) | NOMINAL DIMENSION (Millimeters - unless otherwise specified) |
| --- | --- |
| AP | 11.45 |
| AQ | 135 |
| AR | 73.5 |

From the foregoing dimensions one can calculate extraction feature aspect ratios as follows:

$$\text{Aspect Ratio} = \text{Width of ridge/Greatest height extent of ridge} \qquad (1)$$

Using the foregoing equation, one can calculate (at least approximately) aspect ratios AR1, AR2, AR3, and AR4 of various extraction features 130b, 130d, 130f, and, 130g respectively, denoted in FIG. 7 as follows:

$$AR1 = (N\text{-}M)/(J\text{-}G) = (17.64\text{-}10.44)/(11.9\text{-}4.92) = 7.2/6.98 = 1.032 \qquad (2)$$

$$AR2 = (S\text{-}Q)/(J\text{-}D) = (38.1\text{-}28.5)/(11.9\text{-}4.2) = 9.6/7.7 = 1.247 \qquad (3)$$

$$AR3 = (U\text{-}T)/(B\text{-}D) = (48\text{-}42.18)/(8.1\text{-}4.2) = 5.82/3.9 = 1.492 \qquad (4)$$

$$AR4 = (AN\text{-}U)/(C\text{-}D) = (53.2\text{-}48)/(7.2\text{-}4.2) = 5.2/3.0 = 1.733 \qquad (5)$$

As seen in FIGS. 7, 7A, 8, and 8A and as calculated above in the equations (2)-(5), the extraction features 130 range between aspect ratios of about 1.032 to about 1.733. Preferably, although not necessarily, the present invention contemplates the use of extraction features having aspect ratios that vary between about 0.1 and about 25, and more preferably between about 0.2 and about 8, and most preferably between about 0.3 and about 4. In a waveguide body section having a different size, the dimension(s) of the extraction feature(s) are scaled based on the total thickness of the waveguide while the aspect ratio falls within the ranges noted above.

Further, the height of the extraction features as shown in FIG. 7A ranges from about 3 mm to about 7 mm. Such height depends on the overall thickness of the waveguide body section. Generally, the height of the extraction features may range from about 1 mm to about 60 mm, where a height of 60 mm may be appropriate for a waveguide body section having a thickness of 100 mm. Further, a ratio of extraction feature height to the overall waveguide body thickness can be determined. From the dimensions provided in Table 1, the ratio of extraction feature height to overall waveguide body thickness ranges from about 1:4 to about 1:2. The ratio is preferably between about 1:8 and about 2:3, with ratios between about 1:6 and about 3:4 being more preferred, and ratios between about 1:5 and about 4:5 being most preferred. As noted above, the heights of the extraction features and ratios to the overall thickness of the waveguide body section will depend on the size and geometry of the waveguide body section.

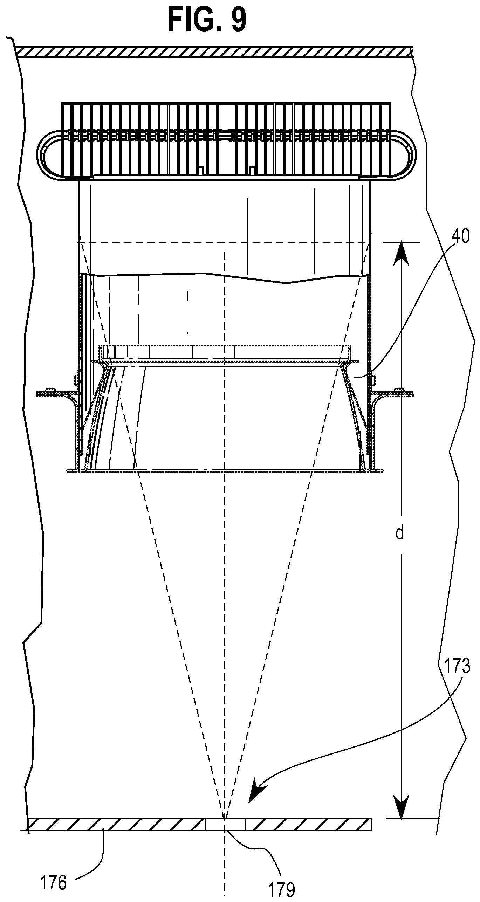

It should be noted that, in the illustrated embodiment, the luminaire 40 may be designed to provide a beam angle that has a minimum transverse spread at a particular distance d from the waveguide body sections 90 and larger transverse spreads at lesser and greater distances from the body sections 90. More particularly, referring to FIG. 9, the extraction features 130 direct light rays emitted at radially outward portions of the waveguide body sections 90 are directed axially inwardly and downwardly (as seen in FIG. 9), with the magnitude of the angle of inward direction being roughly or substantially proportional to the radial distance of emission of the light ray from the center of the luminaire 40. The resulting beam shape is such that a convergence region 173 is formed at a distance d from the outer surface of the waveguide. Light rays diverge at distances greater than d from the body sections 90. This beam shape permits a trim or diffuser ring 176 to have a relatively small diameter aperture 179 but still have a significantly large illumination area beyond the distance d. The result is a reduction in visible glare because of the shielding effect provided by the trim ring 176 and a pleasing aesthetic appearance. In general, the size of the aperture 179 is preferably equal to or smaller than the size of the combined waveguide body sections 90 of the luminaire 40, and, more preferably, the cross sectional size of the aperture 179 relative to the cross sectional size of the combined waveguide body sections 90 is between about 1:2 to about 1:4.

In another embodiment, the luminaire 40 may be designed to create a beam angle that preferably is between less than about 5 degrees to greater than 60 degrees, and more preferably between about 5 degrees and about 50 degrees and most preferably between about 6 degrees and about 40 degrees. The beam peak can either be centered in the nadir (as in a PAR application) or off-center (as in an outdoor application). The beam angle and/or peak can be controlled through appropriate design of the waveguide body sections 90.

In any of the embodiments disclosed herein, the extraction features may be similar or identical to one another in shape, size, and/or pitch, or may be different from one another in any one or more of these parameters, as desired. Further, while the extraction features are shown as extending into the side 112a, it should be noted that one or more extraction features may extend into or be disposed on any of the sides of the body section 90, such as the side 112b.

In the illustrated embodiment, the multiple LED coupling cavities are disposed at locations offset with respect to the geometric center of the luminaire 40, and preferably, at equally spaced radially outer locations in each body section 90. Thus, heat developed by the LED elements disposed in the coupling cavities is spread out and more readily managed. Also, if desired, a sensor, such as an illumination or temperature sensor 150, may be disposed at the center of the luminaire 40, preferably supported by the post 82, as seen in FIG. 1. The sensor may be a part of the power circuit and may develop a feedback signal therefor.

Also preferably, the LED elements 64 are disposed on the circuit board 60 at equal vertical heights. Each waveguide body section 90 includes extraction features 130 that preferably terminate at the side surfaces 96 of the body sections 90. Still further, the extraction features 130 are preferably symmetric about the symmetry plane, and, in the illustrated embodiment, the waveguide body sections 90 are identical to one another. However, the extraction features need not terminate at the side surfaces 96, and may terminate at some other location(s) of the body sections 90. Still further, the extraction features 130 and/or other portions of the body sections 90 need not be identical to corresponding portions of one or more other body sections 90. Accordingly, the distribution of extraction elements over the entire combined set of waveguide sections 90a-90f may be asymmetric when considering the luminaire 40 as a whole so that an overall desired light emission distribution can be obtained. For example, three identical first body sections may be disposed at one side of the luminaire 40 and three identical second body sections may be disposed at another side of the luminaire 40, wherein the first body sections are different than the second body sections so that an asymmetric illumination distribution suitable for a wall wash application may be obtained. Such a feature allows effective optic function in a limited space/size and for modest cost in an application where multiple light elements are used. Also, greater or fewer than six body sections 90 may be utilized, and the sizes of the body sections may the same, as illustrated, or different in any combination. Preferably, a single LED element may be disposed in a coupling cavity of an associated body section, although a body section may include multiple coupling cavities each containing one or more LED elements therein.

By using the features disclosed herein spacing to mounting height ratios of at least about 0.3, and more preferably between about 0.3 and about 1.2.

The circumferential placement of multiple LED lamps and optics overlays the illumination from each LED optic onto each other, which further helps color mixing while maintaining a desired photometric distribution. If necessary or desirable, color mixing may be enhanced by using any of the structures or cavities disclosed in co-pending applications U.S. Patent Application No. 14/101,086, filed December 9, 2013, entitled "Optical Waveguides and Luminaires Incorporating Same," (Cree docket no. P2126US1), U.S. Patent Application No. 14/101,129, filed December 9, 2013, entitled "Waveguide Bodies Including Redirection Features and Methods of Producing Same," (Cree docket no. P2130US1), U.S. Patent Application No. 14/101,147, filed December 9, 2013, entitled "Luminaire Using Waveguide Bodies and Optical Elements" (Cree docket no. P2131US1), and U.S. Patent Application No. 14/101,132, filed December 9, 2013, entitled "Optical Waveguide and Lamp Including Same" (Cree docket no. P2151US1), owned by the assignee of the present application and filed herewith, the disclosures of which are incorporated by reference herein.

If desired, each coupling cavity may extend fully through the associated body section and a light diverter of any suitable shape and design, such as a conical plug member may extend into the coupling cavity as disclosed in copending U.S. Patent Application No. 13/839,949. Also, any of the other features disclosed in co-pending U.S. Patent Application No. 13/839,949 and/or U.S. Patent Application No. 13/840,563 (Cree docket nos. P1961US1 and P2025US1, respectively), may be used in the luminaire 40 as desired.

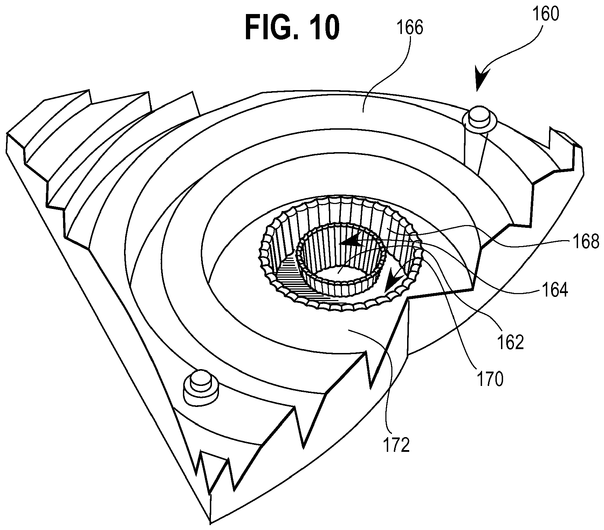

Referring to FIG. 10, an alternative embodiment of the waveguide body section 160 includes a coupling cavity 162 having one or more light coupling features 164 that extend into the waveguide body 166 to enhance light uniformity and color mixing. In general, directing light into a wide range of refraction angles enhances light mixing. Because the angle $A_r$ of a refracted light ray is a function of the angle $A_i$ between the incident light ray and the interface surface struck by the incident light ray (with refractive angle $A_r$ increasing as $A_i$ approaches zero, i.e., when the incident light ray approaches a parallel condition with respect to the interface surface), a wide range of refracted light ray angles can be obtained by configuring the interface surfaces to include a wide range of angles relative to the incident light rays. The coupling cavity 162, which may comprise a blind cavity or a cavity that extends fully through the waveguide body 166, includes one or more light coupling features 164 in the form of a circumferential array of inwardly directed surfaces, shown as bumps or protrusions. The bumps or protrusions, each of which may comprise curved, planar, and/or other-shaped surfaces, promote mixing of light by providing surfaces at varying angles with respect to incident light rays developed by an LED light source 64 (see FIG. 5). The light coupling features may take the form of other shapes, such as, for example, points directed into the waveguide body. Further, it may be desired to include light coupling features 168 along a first surface 170 of an innermost extraction feature 172 that immediately surrounds the coupling cavity 162. In the event that the coupling cavity extends fully through the waveguide body, a light diverter (not shown) may be provided opposite the LED light source 64 (see FIG. 5).

FIGS. 11-16 demonstrate disclosures of a waveguide including varying the numbers of waveguide body sections and/or modifying the location of the light source(s) as described in greater detail below. Such alternative waveguide body sections may be maintained in place relative to one another by any suitable apparatus as in the previous embodiment of FIGS. 1-5.

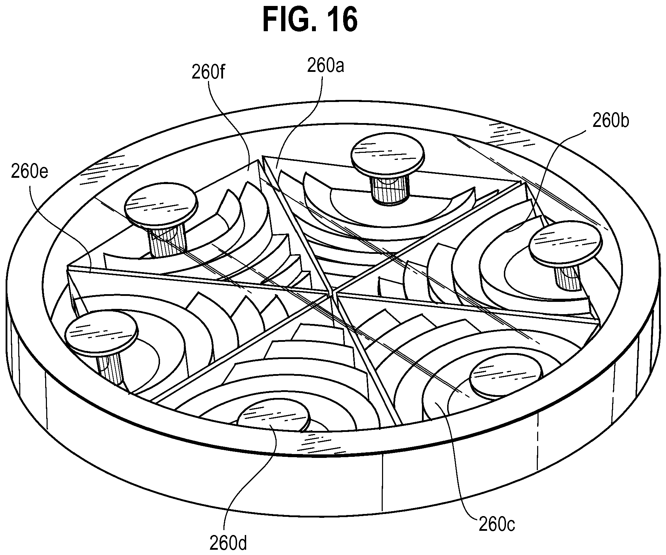

In FIG. 11, the waveguide 200 comprises five identical waveguide body sections 202a-202e. Referring to FIG. 12, each waveguide body section 202 includes a waveguide body 203 having first and second surfaces 204-1, 204-2 and a coupling cavity 206 that extends at least partially between the first and second surfaces 204-1, 204-2. The coupling cavity 206 is preferably (although not necessarily) semicircular cylindrical in overall shape (neglecting the protrusions) and positioned along an outer surface 208 of the waveguide body section 202. An LED element 210 is disposed vertically within each coupling cavity 206. Similar to the embodiment shown in FIG. 10, the coupling cavity 206 includes a plurality of light coupling features 212 that extend into the waveguide body 203. A plate 214 coplanar with the first and/or second surfaces 204-1, 204-2 of the waveguide body 203 may be disposed above and/or below the LED 210. Alternatively, or in addition, a plug member (not shown) may be at least partially disposed in the coupling cavity 206 or formed integrally with the waveguide body 203 adjacent the LED 210 to divert light into the waveguide body section 202. The plate 214 and/or plug member (not shown) may be coated with a reflective white or specular coating or other material, such as paper or a scattering film. Similar to the embodiment shown in FIG. 6, a plurality of extraction features 216 comprise a series of ridges separated by intervening troughs at least some of which define one or more inverted V-shapes in cross section. The extraction features 216 are preferably (although not necessarily) arcuate (preferably annular), and surround and are coaxial with respect to the coupling cavity 206, although the extraction features may be otherwise positioned and/or configured as desired. FIGS. 14 and 16 illustrate further disclosures identical to that shown in FIGS. 11 and 12, except that the five waveguide body sections 202 are replaced by three and six identical waveguide body sections 250a-250c and 260a-260f, respectively, with different extraction feature numbers, spacing, and/or shapes. Further, each waveguide body sections 250a-250c of FIG. 14 has a curved outer surface 252a-252c, in contrast to the relatively linear outer surface 208a-208e of the waveguide body sections 202a-202e in FIGS. 11 and 12.

Referring next to FIG. 13, a waveguide 270 comprises six identical waveguide body sections 272a-272f, wherein each waveguide body section 272 includes a waveguide body 273. A coupling cavity 274 that at least partially extends between first and second surfaces 276-1, 276-2 is positioned along an inner portion 278 of a waveguide body 273. Each coupling cavity 274 is preferably (although not necessarily) semicircular cylindrical in overall shape (neglecting the protrusions) and extraction features 280 similar or identical to the extraction features of previous embodiments may surround the coupling cavity 274 and may be coaxial with respect thereto. FIG. 15 illustrates a disclosure that is identical to the one shown in FIG. 13, except that the six waveguide body sections are replaced by three identical waveguide body sections 290a-290c, with different extraction feature numbers, spacing, and/or shapes, and outer surfaces 292a-292c are tapered to assist in light extraction.

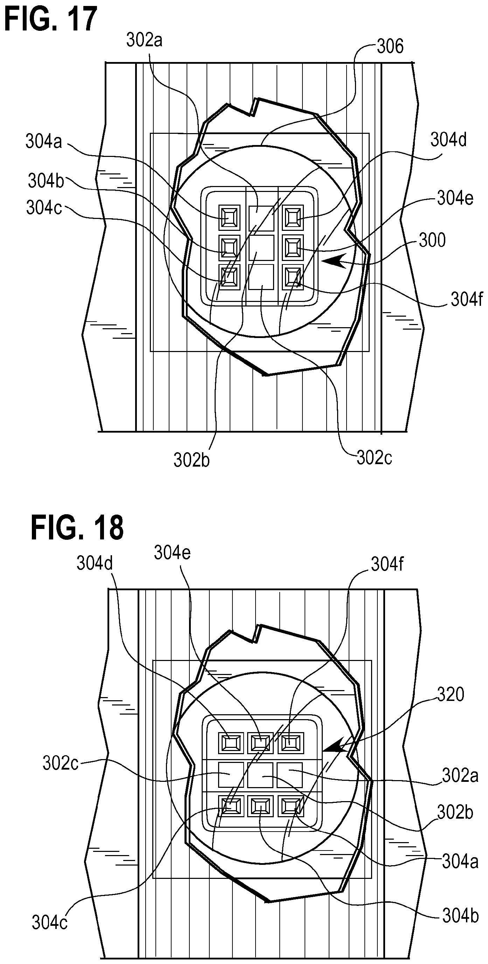

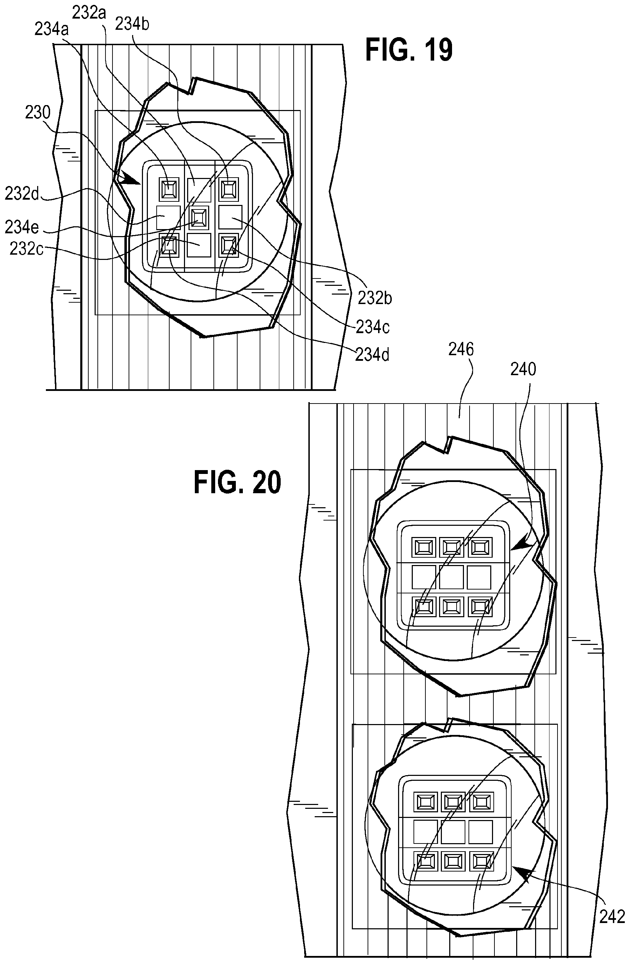

Further, the disclosures shown in FIGS. 11-16 include a light source comprising one or more LEDs disposed vertically such that light emitted from the LEDs is directed directly into the waveguide body sections. In the embodiments of FIGS. 11, 14, and 16, each LED element is disposed on an individual substrate spaced apart along the outer surface of the waveguide body sections. In contrast, each LED element of the embodiments of FIGS. 13 and 15 may be disposed on individual substrates or a common substrate carried by a centrally-disposed carrier 282, 294, respectively. Further, the disclosures of FIGS. 11, 13, and 16 include a single LED element disposed in each coupling cavity, whereas the disclosures of FIGS. 14 and 15 include a plurality of LED elements within each coupling cavity. Referring to FIG. 17, a multi-color LED element 300 includes one or more red LEDs 302a-302c surrounded by a plurality of blue-shifted yellow LEDs 304a-304f. A hemispherical dome lens 306 may be disposed over the LED element 300. The layout of the chips 302, 304 on the vertically disposed LED may be arranged and oriented as shown in FIGS. 17-20. For example, the disclosure shown in FIG. 18 includes an LED element 320 identical to the element 300 shown in FIG. 17, except that the element 320 is rotated 90 degrees (or any other angular extent) about an axis normal to the surface on which the LED component is disposed. Referring to FIG. 19, the LED element 230 includes four red LEDs 232a-232d and five blue-shifted yellow LEDs 234a-234e in a checkerboard pattern. Any LED chip arrangement and/or orientation as disclosed in U.S. Patent Application No. 14/101,147, filed December 9, 2013, entitled "Luminaire Using Waveguide Bodies and Optical Elements" (Cree docket no. P2131US1), owned by the assignee of the present application, may be used in the devices disclosed herein. As shown in FIG. 20, where two LED elements 240, 242 are used, it may be desired to position the LEDs elements 240, 242 within the coupling cavity 246 along a common vertical axis or the LED elements may have different angular orientations, as desired. The orientation, arrangement, and position of the LEDs may be different or identical in each waveguide body section of a waveguide as desired.

Other embodiments of the disclosure including all of the possible different and various combinations of the individual features of each of the foregoing embodiments and examples are specifically included herein. Thus, for example, a waveguide body section may include extraction features of the same or a different shape, and the extraction features may be symmetric or asymmetric, the extraction features may have differing or the same geometry, spacing, size, etc. without departing from the scope of the invention.

INDUSTRIAL APPLICABILITY

As described above, directing light into a wide range of refraction angles enhances light mixing. A wide range of refracted light ray angles can be obtained by configuring the interface surfaces to include a wide range of angles relative to the incident light rays. Overall waveguide shapes and coupling feature and redirection feature shapes such as curved (including convex, concave, and combinations of convex and concave surfaces), planar, non-planar, tapered, segmented, continuous or discontinuous surfaces, regular or irregular shaped surfaces, symmetric or asymmetric shapes, etc. can be used, it being understood that, in general, light mixing (consistent with the necessary control over light extraction) can be further improved by providing an increased number of interface surfaces and/or more complex interface shapes in the light path.

When one uses a relatively small light source which emits into a broad (e.g., Lambertian) angular distribution (common for LED-based light sources), the conservation of etendue, as generally understood in the art, requires an optical system having a large emission area to achieve a narrow (collimated) angular light distribution. In the case of parabolic reflectors, a large optic is thus generally required to achieve high levels of collimation. In order to achieve a large emission area in a more compact design, the prior art has relied on the use of Fresnel lenses, which utilize refractive optical surfaces to direct and collimate the light. Fresnel lenses, however, are generally planar in nature, and are therefore not well suited to re-directing high-angle light emitted by the source, leading to a loss in optical efficiency. In contrast, in the present invention, light is coupled into the optic, where primarily TIR is used for re-direction and collimation. This coupling allows the full range of angular emission from the source, including high-angle light, to be re-directed and collimated, resulting in higher optical efficiency in a more compact form factor.

While specific coupling features and extraction feature parameters including shapes, sizes, locations, orientations relative to a light source, materials, etc. are disclosed as embodiments herein, the present invention is not limited to the disclosed embodiments, inasmuch as various combinations and all permutations of such parameters are also specifically contemplated herein. Any of the features such as various shaped coupling cavities, plug members, LED elements, masking element(s), redirection features, extraction features, etc. described and/or claimed in U.S. Patent Application No. 13/842,521, (Cree docket no. P1946US1), U.S. Patent Application No. 13/839,949, (Cree docket no. P1961US1), U.S. Patent Application No. 13/841,074, filed March 15, 2013, entitled "Optical Waveguide Body" (Cree docket no. P1968US1), U.S. Patent Application No. 13/840,563, (Cree docket no. P2025US1), U.S. Patent Application No. 14/101,086, filed December 9, 2013, entitled "Optical Waveguides and Luminaires Incorporating Same", (Cree docket no. P2126US1), U.S. Patent Application No. 14/101,132, filed December 9, 2013, entitled "Waveguide Bodies Including Redirection Features and Methods of Producing Same," (Cree docket no. P2130US1), U.S. Patent Application No. 14/101,147, filed December 9, 2013, entitled "Luminaire Using Waveguide Bodies and Optical Elements" (Cree docket no. P2131US1), U.S. Patent Application No. 14/101,147, filed December 9, 2013, entitled "Simplified Low Profile Module with Light Guide for Pendant, Surface Mount, Wall Mount and Stand Alone Luminaires" (Cree docket no. P2141US1), and U.S. Patent Application No. 14/101,051, filed December 9, 2013, entitled "Optical Waveguide and Lamp Including Same" (Cree docket no. P2151US1), owned by the assignee of the present application may be used in a luminaire, either alone or in combination with one or more additional elements, or in varying combination(s) to obtain light mixing and/or a desired light output distribution. Thus, for example, any of the waveguides or luminaires disclosed herein may include one or more coupling features, one or more light redirection features, one or more extraction features or optics, and/or particular waveguide or overall luminaire shapes and/or configurations as disclosed in such applications, as necessary or desirable. Other luminaire and waveguide form factors than those disclosed herein are also contemplated.

At least some of the luminaires disclosed herein are particularly adapted for use in installations, such as, replacement or retrofit lamps (e.g., LED PAR bulbs), outdoor products (e.g., streetlights, high-bay lights, canopy lights), and indoor products (e.g., downlights, troffers, a lay-in or drop-in application, a surface mount application onto a wall or ceiling, etc.) preferably requiring a total luminaire output of at least about 800 lumens or greater, and, more preferably, a total luminaire output of at least about 3000 lumens, and most preferably a total lumen output of about 10,000 lumens. Further, the luminaires disclosed herein preferably have a color temperature of between about 2500 degrees Kelvin and about 6200 degrees Kelvin, and more preferably between about 2500 degrees Kelvin and about 5000 degrees Kelvin, and most preferably about 2700 degrees Kelvin. Also, at least some of the luminaires disclosed herein preferably exhibit an efficacy of at least about 100 lumens per watt, and more preferably at least about 120 lumens per watt, and further exhibit a coupling efficiency of at least about 92 percent. Further, at least some of the luminaires disclosed herein preferably exhibit an overall efficiency (i.e., light extracted out of the waveguide divided by light injected into the waveguide) of at least about 85 percent. A color rendition index (CRI) of at least about 80 is preferably attained by at least some of the luminaires disclosed herein, with a CRI of at least about 88 being more preferable. A gamut area index (GAI) of at least about 65 is achievable as is a thermal loss of less than about 10%. Any desired form factor and particular output light distribution, such as a butterfly light distribution, could be achieved, including up and down light distributions or up only or down only distributions, etc.

Embodiments disclosed herein are capable of complying with improved operational standards as compared to the prior art as follows:

|  | State of the art standards | Improved standards achievable by present embodiments |
|---|---|---|
| Input coupling efficiency (coupling + waveguide) | 90% | About 95% plus improvements through color mixing, source mixing, and control within the waveguide |
| Output efficiency (extraction) | 90% | About 95%: improved through extraction efficiency plus controlled distribution of light from the waveguide |
| Total system | ~ 80% | About 90%: great control, many choices of output distribution |

In at least some of the present embodiments the distribution and direction of light within the waveguide is better known, and hence, light is controlled and extracted in a more controlled fashion. In standard optical waveguides, light bounces back and forth through the waveguide. In the present embodiments, light is extracted as much as possible over one pass through the waveguide to minimize losses.

In some embodiments, one may wish to control the light rays such that at least some of the rays are collimated, but in the same or other embodiments, one may also wish to control other or all of the light rays to increase the angular dispersion thereof so that such light is not collimated. In some embodiments, one might wish to collimate to narrow ranges, while in other cases, one might wish to undertake the opposite.

Numerous modifications to the present disclosure will be apparent to those skilled in the art in view of the foregoing description. Preferred embodiments of this disclosure are described herein, including the best mode known to the inventors for carrying out the disclosure. It should be understood that the illustrated embodiments are exemplary only, and should not be taken as limiting the scope of the disclosure.

**Claims**

1.   A light engine (44) comprising:

an optical waveguide (88) comprising a plurality of body sections (90a-90f) comprising a recess (98a-98f, 162) for receiving at least one LED (64) and a plurality of curved light extraction features (130) surrounding the recess;
a mounting structure (92) surrounding the plurality of body sections that maintains the plurality of body sections in assembled relationship;
a base mounting surface (76); and
a plurality of LEDs (64) disposed on a circuit board (60) wherein the circuit board, the mounting structure, and assembled body sections are secured relative to the base mounting surface (76),
**characterized in that** each body section (90a-90f) is of a wedge shape and further comprises first and second continuously curved outer walls (122a, 122b) disposed at an outer portion of the optical waveguide (88) and that meet at an inflection portion (121) spaced from another body section.

2.   The light engine of claim 1, further comprising a heat exchanger (46) in thermal communication with at least one of: the base mounting surface (76) and the plurality of LEDs (64).

3.   The light engine of claim 2, wherein the base mounting surface (76) is secured to the heat exchanger (46).

4.   The light engine of claim 1, wherein the mounting structure (92) comprises at least one of a specular reflective inner surface and a reflective white inner surface adjacent and substantially conforming to outer surfaces of the plurality of body sections (90a-90f).

5. The light engine of claim 1, wherein the recess (98a-98f, 162) of each body section (90a-90f) is radially aligned with and proximate the inflection portion (121) of the body section.

6. The light engine of claim 5, wherein the extraction features (130) of each body section (90a-90f) are concentric with respect to the recess (98a-98f, 162) of such body section.

7. The light engine of claim 1, wherein the recess (98a-98f, 162) is defined by a plurality of side walls (120a- 1201) and a base wall (118).

8. The light engine of claim 7, wherein the side walls (120a- 1201) are tapered and planar.

9. The light engine of claim 1, further comprising a carrier (282, 294) that is disposed against an inner portion (94a-94f) of each body section (90a-90f), wherein the circuit board (60) is secured to the carrier.

10. The light engine of claim 1, wherein each recess (98a-98f, 162) is disposed on an outer surface of each body section (90a-90f).

11. The light engine of claim 1, wherein the aspect ratios of the plurality of curved light extraction features (130) vary between about 0.1 to about 25.

12. The light engine of claim 11, wherein the aspect ratios of the plurality of curved light extraction features (130) vary between about 0.2 to about 8.

13. The light engine of claim 1, wherein the at least one LED (64) comprises first and second sets of LEDs wherein each LED of the first set comprises at least one LED of a first spectral emission characteristic and at least one LED of a second different spectral emission characteristic.

14. The light engine of claim 1, wherein all of the body sections are shaped substantially identical to one another.


**Patentansprüche**

1. Licht-Engine (44), umfassend:

einen optischen Wellenleiter (88), der eine Vielzahl von Körperabschnitten (90a-90f) umfasst, die eine Vertiefung (98a-98f, 162) zum Aufnehmen von mindestens einer LED (64) und eine Vielzahl von gekrümmten Lichtextraktionsmerkmalen (130) umfassen, welche die Vertiefung umgeben;
eine die Vielzahl von Körperabschnitten umgebende Montagestruktur (92), die die Vielzahl von Körperabschnitten in verbundener Beziehung hält;
eine Basismontagefläche (76); und
eine Vielzahl von LEDs (64), die auf einer Leiterplatte (60) angeordnet sind, wobei die Leiterplatte, die Montagestruktur und verbundenen Körperabschnitte relativ zur Basismontagefläche (76) gesichert sind,
**dadurch gekennzeichnet, dass** jeder Körperabschnitt (90a-90f) von einer Keilform ist und weiter erste und zweite kontinuierlich gekrümmte Außenwände (122a, 122b) umfasst, die an einem Außenabschnitt des optischen Wellenleiters (88) angeordnet sind und die an einem von einem anderen Körperabschnitt beabstandeten Beugungsabschnitt (121) zusammentreffen.

2. Licht-Engine nach Anspruch 1, weiter einen Wärmetauscher (46) umfassend, der mit mindestens einem in thermischer Kommunikation steht aus: der Basismontagefläche (76) und der Vielzahl von LEDs (64).

3. Licht-Engine nach Anspruch 2, wobei die Basismontagefläche (76) am Wärmetauscher (46) gesichert ist.

4. Licht-Engine nach Anspruch 1, wobei die Montagestruktur (92) mindestens eine aus einer spiegelreflektierenden Innenfläche und einer reflektierenden weißen Innenfläche umfasst, die an Außenflächen der Vielzahl von Körperabschnitten (90a-90f) angrenzt und sich im Wesentlichen an dieselben anformt.

5. Licht-Engine nach Anspruch 1, wobei die Vertiefung (98a-98f, 162) jedes Körperabschnitts (90a-90f) radial zum Beugungsabschnitt (121) des Körperabschnitts ausgerichtet ist und demselben nahe liegt.

6. Licht-Engine nach Anspruch 5, wobei die Extraktionsmerkmale (130) jedes Körperabschnitts (90a-90f) in Bezug auf die Vertiefung (98a-98f, 162) eines derartigen Körperabschnitts konzentrisch sind.

7. Licht-Engine nach Anspruch 1, wobei die Vertiefung (98a-98f, 162) von einer Vielzahl von Seitenwänden (120a-120l) und einer Basiswand (118) definiert wird.

8. Licht-Engine nach Anspruch 7, wobei die Seitenwände (120a-120l) planar sind und sich verjüngen.

9. Licht-Engine nach Anspruch 1, weiter einen Träger (282, 294) umfassend, der an einem Innenabschnitt (94a-94f) jedes Körperabschnitts (90a-90f) angeordnet ist, wobei die Leiterplatte (60) am Träger gesichert ist.

10. Licht-Engine nach Anspruch 1, wobei jede Vertiefung (98a-98f, 162) an einer Außenfläche jedes Körperabschnitts (90a-90f) angeordnet ist.

11. Licht-Engine nach Anspruch 1, wobei die Seitenverhältnisse der Vielzahl von gekrümmten Lichtextraktionsmerkmale (130) zwischen etwa 0,1 bis etwa 25 variieren.

12. Licht-Engine nach Anspruch 11, wobei die Seitenverhältnisse der Vielzahl von gekrümmten Lichtextraktionsmerkmale (130) zwischen etwa 0,2 bis etwa 8 variieren.

13. Licht-Engine nach Anspruch 1, wobei die mindestens eine LED (64) erste und zweite LED-Sätze umfasst, wobei jede LED des ersten Satzes mindestens eine LED einer ersten spektralen Emissionscharakteristik und mindestens eine LED einer zweiten, unterschiedlichen spektralen Emissionscharakteristik umfasst.

14. Licht-Engine nach Anspruch 1, wobei alle der Körperabschnitte im Wesentlichen miteinander identisch geformt sind.

**Revendications**

1. Générateur de lumière (44) comprenant :

   un guide d'onde optique (88) comprenant une pluralité de sections de corps (90a à 90f) comprenant un évidement (98a à 98f, 162) pour recevoir au moins une DEL (64) et une pluralité d'éléments d'extraction de lumière incurvés (130) entourant l'évidement ;
   une structure de montage (92) entourant la pluralité de sections de corps qui maintient la pluralité de sections de corps en relation assemblée ;
   une surface de montage de base (76) ; et
   une pluralité de DEL (64) disposées sur une carte de circuit (60), dans lequel la carte de circuit, la structure de montage et les sections de corps assemblées sont fixées par rapport à la surface de montage de base (76), **caractérisé en ce que** chaque section de corps (90a à 90f) est en forme de cale et comprend en outre des première et seconde parois externes incurvées en continu (122a, 122b) disposées au niveau d'une portion externe du guide d'onde optique (88) et qui se rencontrent au niveau d'une portion d'inflexion (121) espacée d'une autre section de corps.

2. Générateur de lumière selon la revendication 1, comprenant en outre un échangeur de chaleur (46) en communication thermique avec au moins l'une parmi : la surface de montage de base (76) et la pluralité de DEL (64).

3. Générateur de lumière selon la revendication 2, dans lequel la surface de montage de base (76) est fixée à l'échangeur de chaleur (46).

4. Générateur de lumière selon la revendication 1, dans lequel la structure de montage (92) comprend au moins l'une parmi une surface interne réfléchissante spéculaire et une surface interne blanche réfléchissante adjacente et se conformant sensiblement à des surfaces externes de la pluralité de sections de corps (90a à 90f).

5. Générateur de lumière selon la revendication 1, dans lequel l'évidement (98a à 98f, 162) de chaque section de corps (90a à 90f) est radialement aligné à la portion d'inflexion (121) de la section de corps et proche de celle-ci.

6. Générateur de lumière selon la revendication 5, dans lequel les éléments d'extraction (130) de chaque section de corps (90a à 90f) sont concentriques par rapport à l'évidement (98a à 98f, 162) de cette section de corps.

7. Générateur de lumière selon la revendication 1, dans lequel l'évidement (98a à 98f, 162) est défini par une pluralité de parois latérales (120a à 120l) et une paroi de base (118).

8. Générateur de lumière selon la revendication 7, dans lequel les parois latérales (120a à 120l) sont effilées et planes.

9. Générateur de lumière selon la revendication 1, comprenant en outre un support (282, 294) qui est disposé contre une portion interne (94a à 94f) de chaque section de corps (90a à 90f), dans lequel la carte de circuit (60) est fixée au support.

10. Générateur de lumière selon la revendication 1, dans lequel chaque évidement (98a à 98f, 162) est disposé sur une surface externe de chaque section de corps (90a à 90f).

11. Générateur de lumière selon la revendication 1, dans lequel les facteurs de forme de la pluralité d'éléments d'extraction de lumière incurvés (130) varient entre environ 0,1 et environ 25.

12. Générateur de lumière selon la revendication 11, dans lequel les facteurs de forme de la pluralité d'éléments d'extraction de lumière incurvés (130) varient entre environ 0,2 et environ 8.

13. Générateur de lumière selon la revendication 1, dans lequel l'au moins une DEL (64) comprend des premier et second ensembles de DEL, dans lequel chaque DEL du premier ensemble comprend au moins une DEL d'une première caractéristique d'émission spectrale et au moins une DEL d'une seconde caractéristique d'émission spectrale différente.

14. Générateur de lumière selon la revendication 1, dans lequel toutes les sections de corps sont de forme sensiblement identique les unes par rapport aux autres.

# FIG. 1

# FIG. 2

# FIG. 3

# FIG. 4

# FIG. 5

**7,7A**

**FIG. 6**

110

90

122a

98

121

112b

112a

122b

**7,7A**

**FIG. 7**

110  120a  112b  118  120g  90  122a

130a

120h

120i

120j

120

130g  130f  130e  134  130d  132  130c  130b  112a  120l  98  99  120k

FIG. 7A

FIG. 8

122b
120f
120e
110
120d
120c
98
112a
120b
118
120a
90  121
120l
90
120g
120h
122a
120i
120j  120k

FIG. 8A

112a
90
AL
AM
AP
AQ
AN
98
110
AR

# FIG. 9

FIG. 10

# FIG. 11

**FIG. 12**

**FIG. 13**

# FIG. 14

250c    250a

252b

250b    252a

252b

# FIG. 15

294    290a

290c

290b

292a

292b

# FIG. 16

# FIG. 17

# FIG. 18

FIG. 19

FIG. 20

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5812714 A
- US 5613751 A, Parker
- US 3532871 A, Shipman
- US 5897201 A, Simon
- US 8430548 B, Kelly
- US 8506112 B, Dau
- US 2010128483 A1, REO
- US 5806955 A, PARKYN
- US 2008186273 A1
- US 64906712

- US 8541795 B
- US 839949
- US 10108613
- US 10112913
- US 10114713
- US 10113213
- US 840563
- US 842521
- US 84107413
- US 10105113